# EUROPÄISCHE PATENTSCHRIFT

(11) **EP 3 465 242 B1**
(45) Veröffentlichungstag und Bekanntmachung des Hinweises auf die Patenterteilung: **17.07.2024**
(21) Anmeldenummer: 17733974.4
(22) Anmeldetag: 31.05.2017
(51) Int. Cl.: G01R 31/378, G01R 31/44, H01M 10/48

(54) **GLEICHSTROMIMPULS-BATTERIETESTGERÄT UND VERFAHREN ZUR ERKENNUNG EINES BATTERIETYPS**
DC PULSE BATTERY TESTING DEVICE AND METHOD FOR DETERMINING A BATTERY TYPE
APPAREIL DE TEST DE BATTERIE À IMPULSION DE COURANT CONTINU ET PROCÉDÉ DE RECONNAISSANCE D'UN TYPE DE BATTERIE

(30) Priorität: 31.05.2016 DE 102016006419
(43) Veröffentlichungstag der Anmeldung: 10.04.2019
(73) Patentinhaber: Berghof Automation GmbH, 72800 Eningen (DE)
(72) Erfinder: MISKA, Philipp, 99998 Weinbergen (DE); GÖRLS, Christopher, 99974 Mühlhausen (DE)
(74) Vertreter: Forstmeyer, Dietmar
(86) Internationale Anmeldenummer: PCT/EP2017/063190
(87) Internationale Veröffentlichungsnummer: WO 2017/207650

(56) Entgegenhaltungen:
- EP-A2- 1 065 774
- DE-A1- 102010 062 412
- DE-T2- 69 424 696
- US-A- 5 489 835
- US-A1- 2008 309 284
- US-A1- 2012 235 593
- US-A1- 2016 018 471
- US-B1- 6 404 164

## Beschreibung

Die Erfindung betrifft ein Batterietestgerät für eine über das Bordnetz an die Verbraucher eines Fahrzeuges angeschlossene Fahrzeugbatterie mit einer Spannungsmesseinheit und einem Gleichstromgenerator, sowie ein Verfahren zur Erkennung eines Batterietyps einer über das Bordnetz an die Verbraucher eines Fahrzeuges angeschlossenen Batterie mittels eines Batterietestgeräts.

Insbesondere in Fahrzeugen, aber auch in anderen Maschinen, werden Akkumulatoren (nachfolgend synonym auch als Batterien bezeichnet) verwendet, um elektrische Energie für einen Elektromotor, für elektrische Verbraucher und/oder Starterenergie für einen Brennstoffmotor zu Verfügung zu stellen. In vielen solchen Anwendungen, so auch im Bereich der straßengebundenen Kraftfahrzeuge, ist häufig die Lebensdauer der Batterie niedriger ausgelegt als die des Fahrzeuges. Daher muss bei solchen Anwendungen von Zeit zu Zeit die Batterie getestet und gegebenenfalls ausgetauscht werden. Ob ein Austausch erforderlich ist, wird beispielsweise in Kfz-Werkstätten mittels eines Batterietestgerätes ermittelt, welches nach Anschluss des Gerätes an die Batterie ermittelt, ob die Batterie aufgrund einer bereits zu hohen Alterung und entsprechender Degenerierung ihrer Leistungsfaktoren ausgetauscht werden muss. Auch in Testlaboren, beispielsweise von Fahrzeugherstellern oder Teilezulieferern können solche Batterietestgeräte Anwendung finden, ebenso wie in Fertigungslinien der Automobilhersteller.

In der US 5,489,835 sind ein Verfahren und eine Vorrichtung zum Identifizieren des Batterietyps einer Batterie während des Wiederaufladens beschrieben. In der US 2012/0235593 A1 sind eine elektronische Schaltung und ein Verfahren zum Bestimmen eines Typs und/oder einer Größe einer Batterie in einer tragbaren Leuchte beschrieben. In der DE 694 24 696 T2 sind eine Schaltung und ein Verfahren zur Identifizierung des Zellentyps einer Batterie beschrieben, während sich die Batterie in der Schaltung und im Betrieb befindet. In der US 2016/0018471 A1 ist ein Verfahren zum Bestimmen des Zustands einer Batterie beschrieben. In der DE 10 2010 062412 A1 sind ein Verfahren und ein System zum Bestimmen der Art einer Batterie in einem Kraftfahrzeug beschrieben.

Lange Jahre waren für Fahrzeugakkumulatoren im Wesentlichen Batterien aus geeignet verschalteten Bleiakkumulatorzellen als Sekundärzellenbasis im Einsatz. Aufgrund des immer größeren Umfangs der in einem Fahrzeug benötigten elektrischen Leistung, die aus einem verstärkten Bedarf von elektrischen Verbrauchern ebenso resultieren kann wie aus der Anwendung von Hybridantriebskonzepten mit Verbrennungs- und Elektromotor, hat sich aber in den letzten Jahren eine verstärkte Verwendung von Fahrzeugbatterien aus andern Sekundärzellen, beispielsweise Lithiumionen-Sekundärzellen (Li-Ion) ergeben.

Es ist daher zunehmend schwierig, mit herkömmlichen Batterietestgeräten zuverlässige Aussagen über die alterungsbedingte Leistungsfähigkeit einer Fahrzeugbatterie zu treffen, insbesondere weil die elektrochemischen Vorgänge in Batterien mit unterschiedlicher Sekundärzellenbasis (sprich: bei verschiedenen Batterietypen) sehr unterschiedlich sind.

Eine besondere Herausforderung ist auch, eine zuverlässige Aussage bezüglich des verbauten Batterietyps zu erhalten, wenn der Test mit im Fahrzeug eingebauter Batterie durchgeführt werden soll. Dies ist aber häufig wünschenswert, weil es umständlich bzw. in bestimmten Situationen wie der Fahrzeugfertigung nicht gewünscht ist, die Batterie vor dem Test auszubauen.

Es ist daher eine Aufgabe der Erfindung, ein Batterietestgerät zur Verfügung zu stellen, das die Erkennung, Identifizierung und/oder Unterscheidung unterschiedlicher Batterietypen zuverlässig ermöglicht.

Diese Aufgabe wird durch ein Verfahren zur Erkennung eines Batterietyps gemäß Anspruch 1 sowie durch ein Batterietestgerät gemäß Anspruch 9 gelöst.

Die vorliegende Erfindung betrifft ein Verfahren zur Erkennung des Batterietyps (Pb, Li-Ion) einer über das Bordnetz an die Verbraucher eines Fahrzeuges angeschlossenen Batterie mittels eines Batterietestgeräts, gekennzeichnet durch die Schritte:
- Beaufschlagen einer zu testenden Batterie mit einem Gleichstromimpuls mit einer Stromstärke (IB) von wenigstens 30 Ampere während wenigstens fünf Sekunden,
- vor dem Beaufschlagen Messen einer Vorimpulsspannung (U0) der Batterie,
- während dem Beaufschlagen Messen einer Impulsspannung (U1) der Batterie,

- Ermitteln einer Übergangs-Spannungsdifferenz zwischen der Vorimpulsspannung und der Impulsspannung,
- Ermitteln einer Ausprägung eines Übergangs-Spannungsdifferenz-Parameters in Abhängigkeit von der Übergangs-Spannungsdifferenz,
- in Abhängigkeit von der Ausprägung Zuordnen eines bestimmten Batterietyps (Pb, Li-Ion) zu der getesteten Batterie.

Die vorliegende Erfindung betrifft weiterhin ein Batterietestgerät für eine über das Bordnetz an die Verbraucher eines Fahrzeuges angeschlossene Fahrzeugbatterie, aufweisend eine Spannungsmesseinheit, gekennzeichnet dadurch, dass das Batterietestgerät einen Stromimpulsgenerator zur Erzeugung eines Gleichstromimpulses aufweist, wobei die Spannungsmesseinheit und der Stromimpulsgenerator jeweils mit den Polen der zu testenden Fahrzeugbatterie verbunden werden können, und dadurch, dass das Batterietestgerät eingerichtet ist,
- zu mehreren Zeitpunkten (T0-T14) vor und während einer Beaufschlagung der Fahrzeugbatterie mit einem Gleichstromimpuls mit einer Stromstärke (IB) von wenigstens 30 Ampere während wenigstens fünf Sekunden jeweils eine Spannung (U0-U14) der Batterie zu messen,
- aus wenigstens einem, insbesondere mehreren, Paaren von gemessenen Spannungen jeweils eine Spannungsdifferenz zu ermitteln,
- in Abhängigkeit von der/n ermittelten Spannungsdifferenz(en) jeweils eine Ausprägung eines Spannungsdifferenz-Parameters zu ermitteln,
- bezüglich jedes Spannungsdifferenz-Parameters der getesteten Fahrzeugbatterie in Abhängigkeit von der jeweiligen Ausprägung einen bestimmten Batterietyp (Pb, Li-Ion) zuzuordnen.

Unter einem Batterietyp im Sinne der Erfindung ist vorzugsweise eine Menge von ggfs. anderweitig unterschiedlichen Batterien zu verstehen, die aber alle eine gleichartige Sekundärzellenbasis aufweisen, also insbesondere eine wenigstens im Wesentlichen gleiche galvanische Paarung.

Die Erfindung basiert unter anderem auf der Erkenntnis, dass Batterien auf unterschiedlicher Sekundärzellbasis (also unterschiedliche Batterietypen) unterschiedliches Spannungsverhalten und unterschiedliche Spannungsentwicklungen über die Zeit aufweisen, insbesondere während und/oder nach der Einleitung eines Gleichstromimpulses über mehrere Sekunden in die Batterie. Ein Batterietestgerät nach einer Ausführung der Erfindung ist, beispielsweise bei Durchführung eines Verfahrens im Sinne der Erfindung, insbesondere in der Lage, dieses unterschiedliche Spannungsverhalten und die unterschiedliche Spannungsentwicklung von Batterien verschiedener Typen zu messen, zu verarbeiten, bestimmten Batterietypen zuzuordnen und diese damit zu erkennen.

Nachfolgend ist die Erfindung hauptsächlich im Kontext der Unterscheidung von Bleibatterien und Li-Ion-Batterien für Kraftfahrzeuge dargestellt, wenngleich der Erfindungsgedanke sich allgemein auf eine Erkennung beliebiger Batterietypen in dem Sinne bezieht, dass mittels eines Batterietestgeräts und/oder eines Verfahrens im Sinne der Erfindung eine Erkennung bestimmter oder beliebiger galvanischer Paarungen als Sekundärzellen eines dadurch definierten Batterietyps ermöglicht wird.

Der aufgebrachte Gleichstrom-Impuls weist insbesondere eine Stromstärke von 30, 35, 40, 50, 60, 70, 80, 90, 100, 120 oder 130 Ampere, vorzugsweise von zwischen 60 und 100 Ampere, auf, und weist vorzugsweise - je nach Anwendungsfall - eine Spannung von 14,4 V oder 14,7 V oder 14,9 V oder 15,2 V auf, insbesondere bei einem Test, der auf eine Unterscheidung von Li-Ion-Batterie und Blei-Batterien abzielt. Je nach Test-Setting kann der entsprechende Impuls während einer, zwei, fünf, acht, zehn, zwölf, 15, 20 oder 30 Sekunden, vorzugsweise während acht bis zwölf Sekunden, aufgebracht werden.

Ein Vorteil des Aufbringens eines Gleichstroms mit einer derart hohen Stromstärke während eines derart langen Zeitraums besteht insbesondere darin, dass der Batterietest an einer in einem Fahrzeug eingebauten und angeschlossenen Batterie durchgeführt werden kann, ohne dass die angeschlossenen Verbraucher und/oder das angeschlossene Bordnetz das Testergebnis nennenswert verfälschen.

Insbesondere wird in diesem Fall das elektrische System des Fahrzeuges mit der Batterie durch den Gleichstromimpuls derart angeregt, dass eventuelle Einwirkungen der Anschlussumgebung auf die Batterie im Verhältnis so klein sind, dass sie das Testergebnis nicht in relevanter Weise beeinflussen können.

Gemäß einer Ausführung des Verfahrens weist der Gleichstromimpuls eine wenigstens im Wesentlichen konstante Stromstärke im Bereich von zwischen 60 und 120 Ampere auf, insbesondere um Einflüsse einer Anschlussumgebung einer eingebauten, zu testenden Batterie, zu überdecken.

Um die Entwicklung der Spannung (und gegebenenfalls auch des Antwortstroms) über die Zeit während des Impulses ausreichend lang beobachten zu können, wird gemäß einer Ausführung die Batterie mit dem Gleichstromimpuls während einer Zeitdauer im Bereich von zwischen acht und 15 Sekunden beaufschlagt.

Dazu können gemäß einer Ausführung auch die folgenden Verfahrensschritte durchgeführt werden: Messen wenigstens einer weiteren Impulsspannung der Batterie zu wenigstens einem weiteren Zeitpunkt während der Beaufschlagung; Ermitteln einer Ausprägung wenigstens eines Impuls-Spannungsdifferenz-Parameters in Abhängigkeit von einer Impuls-Spannungsdifferenz zwischen zwei gemessenen Impulsspannungen; in Abhängigkeit von der Ausprägung Zuordnen eines bestimmten Batterietyps zu der getesteten Batterie.

Vorzugsweise wird hierbei zu mehreren, insbesondere insgesamt zehn oder fünfzehn, Zeitpunkten während der Beaufschlagung eine Impulsspannung der Batterie gemessen; und eine Ausprägung wenigstens eines weiteren Impuls-Spannungsdifferenz-Parameters in Abhängigkeit von wenigstens einer Impuls-Spannungsdifferenz zwischen zwei der gemessenen Impulsspannungen ermittelt; und in Abhängigkeit von der Ausprägung ein bestimmter Batterietyp zu der getesteten Batterie zugeordnet.

Eine Aufnahme von Spannungswerten (und gegebenenfalls Antwortstromwerten) zu verhältnismäßig vielen Zeitpunkten während des Gleichstromimpulses kann bei der Erkennung des Batterietyps insbesondere dann helfen, wenn die zu testende Batterie nicht im maximalen Ladungszustand, sondern in einem unbekannten Teilladungszustand getestet wird. Hierfür kommen beispielsweise die nachfolgend genannten Zuordnungsparameter infrage.

Um die Erkennung des Batterietyps bei Batterien in beliebigem Ladezustand zu erleichtern, wird gemäß einer Ausführung in Abhängigkeit von einem Mittelwert auftretender Spannungsdifferenzen zwischen zeitlich benachbart vor und während der Beaufschlagung gemessenen Spannungen eine Ausprägung eines Spannungsdifferenz-Mittelwert-Parameters ermittelt, und in Abhängigkeit von der Ausprägung ein bestimmter Batterietyp zu der getesteten Batterie zugeordnet.

Gemäß einer Ausführung wird in Abhängigkeit von einer zeitlichen Entwicklung der Spannungsänderungen zwischen zeitlich benachbart vor und während der Beaufschlagung gemessenen Spannungen eine Ausprägung eines Spannungsdifferenz-Ableitungs-Parameters ermittelt, und in Abhängigkeit von der Ausprägung ein bestimmter Batterietyp zu der getesteten Batterie zugeordnet. Auch dies kann die Erkennung des Batterietyps bei Batterien in beliebigem Ladezustand erleichtern.

Insbesondere bei Tests von Batterien in einem maximalen Ladezustand wird gemäß einer Ausführung in Abhängigkeit von der Vorimpulsspannung eine Ausprägung eines Vorimpulsspannungs-Parameters ermittelt, und in Abhängigkeit von der Ausprägung ein bestimmter Batterietyp zu der getesteten Batterie zugeordnet.

Um die Unterscheidung von Batterietypen bei Batterien im maximalen Ladezustand weiter zu erleichtern, wird gemäß einer Ausführung während der Beaufschlagung mit dem Gleichstromimpuls zu mehreren Zeitpunkten jeweils ein Impulsantwortstrom gemessen; und in Abhängigkeit von wenigstens einer Stromdifferenz zwischen zwei gemessenen Impulsantwortströmen eine Ausprägung wenigstens eines Impulsstromdifferenzparameters ermittelt; und in Abhängigkeit von der Ausprägung ein bestimmter Batterietyp zu der getesteten Batterie zugeordnet.

Mit dem gleichen Ziel kann gemäß einer Ausführung auch in Abhängigkeit von wenigstens einer Beaufschlagungs-Stromdifferenz zwischen dem Beaufschlagungsstrom und einem gemessenen Impulsantwortstrom eine Ausprägung eines Beaufschlagungs-Stromdifferenz-Parameters ermittelt werden, und in Abhängigkeit von der Ausprägung ein bestimmter Batterietyp zu der getesteten Batterie zugeordnet werden.

Vorzugsweise wird dabei zu mehreren, insbesondere insgesamt zehn oder fünfzehn, Zeitpunkten vor oder während der Beaufschlagung ein Impulsantwortstrom der Batterie gemessen (insbesondere zu einem Zeitpunkt vor und 14 Zeitpunkten während des Impulses), eine Ausprägung wenigstens eines weiteren Impulsstromdifferenzparameters in Abhängigkeit von wenigstens einer Stromdifferenz zwischen zwei der gemessenen Impulsantwortströme ermittelt, und in Abhängigkeit von der Ausprägung ein bestimmter Batterietyp zu der getesteten Batterie zugeordnet.

Um dem Batterietest auch Aussagen zugrunde legen zu können, die aus einem Verhältnis einer gemessenen Spannung und eines gemessenen Antwortstroms resultieren, werden gemäß einer Ausführung zu mehreren, insbesondere insgesamt zehn oder fünfzehn, Zeitpunkten während der Beaufschlagung sowohl eine Impulsspannung als auch ein Impulsantwortstrom der Batterie gemessen.

Gemäß einer Ausführung ist vorgesehen, dass der Batterietest nur dann ein Ergebnis liefert, wenn sämtliche oder eine gewisse Anzahl, beispielsweise die Mehrheit, der betrachteten Zuordnungsparameter aufgrund der jeweils vorliegenden Ausprägung eine Zuordnung zum selben Batterietyp ergeben.

Bei einer solchen Ausführung wird in Abhängigkeit von der Zuordnung der getesteten Batterie zu einem bestimmten Batterietyp bezüglich eines oder mehrerer Parameter, insbesondere der betrachteten Zuordnungsparameter, eine Zuweisung eines bestimmten Batterietyps als Testergebnis zugewiesen, wenn bezüglich aller oder eines vorbestimmten Anteils der betrachteten Parameter eine Ausprägung vorliegt, die demselben Batterietyp zugeordnet ist. Damit kann gemäß der benötigten Aussagegenauigkeit für den jeweiligen Anwendungsfall die Verlässlichkeit des Batterietests angepasst werden.

Um die verschiedenen Ausführungen des Verfahrens mit einem geeigneten Batterietestgerät durchführen zu können, werden entsprechende Ausführungen eines solchen Batterietestgeräts bereitgestellt:
Gemäß einer Ausführung wird ein Batterietestgerät bereitgestellt, zusätzlich aufweisend eine Strommesseinheit, wobei das Batterietestgerät zusätzlich eingerichtet ist: zu mehreren Zeitpunkten vor, während und/oder nach der Beaufschlagung der Fahrzeugbatterie mit dem Gleichstromimpuls jeweils einen Antwortstrom der Batterie zu messen; aus wenigstens einem, insbesondere mehreren, Paaren von gemessenen Antwortströmen jeweils eine Stromdifferenz zu ermitteln; in Abhängigkeit von der/n ermittelten Stromdifferenz(en) jeweils eine Ausprägung eines Zuordnungsparameters zu ermitteln.

Gemäß einer Ausführung ist das Batterietestgerät zusätzlich eingerichtet, aus einem einzelnen gemessenen Spannungs- und/oder Stromwert der Batterie und/oder aus einer Stromdifferenz zwischen dem Beaufschlagungsstrom und einem gemessenen Strom eine Ausprägung eines Zuordnungsparameters zu ermitteln.

Das Batterietestgerät ist gemäß einer Ausführung zusätzlich eingerichtet, bei Übereinstimmung aller vorgenommenen Zuordnungen hinsichtlich des zugeordneten Batterietyps, der getesteten Fahrzeugbatterie diesen Batterietyp als Ergebnis des Batterietests zuzuweisen.

Wenn vorliegend von einem Parameter die Rede ist, ist dies im Zweifel im Sinne eines Zuordnungsparameters zum Erkennen des Batterietyps zu verstehen, es sei denn aus dem Text geht anderes hervor. Insbesondere ist unter den nachfolgend genannten Parametern ein Zuordnungsparameter zu verstehen: Übergangs-Spannungsdifferenz-Parameter, Impuls-Spannungsdifferenz-Parameter, Spannungsdifferenz-Mittelwert-Parameter, Spannungsdifferenz-Ableitungs-Parameter, Vorimpulsspannungs-Parameter, Impulsstromdifferenzparameter, Beaufschlagungs-Stromdifferenz-Parameter.

Die Zuordnung einer bestimmten Ausprägung eines Zuordnungsparameters zu einem bestimmten Batterietyp kann gemäß einer Ausführung anhand eines Vergleichs mit Erfahrungswerten und/oder mit für einen Batterietyp typischen Batteriemodellen hinsichtlich des betrachteten Zuordnungsparameters erfolgen. Die Umsetzung erfolgt vorzugsweise computergestützt, beispielsweise mittels eines softwareimplementierten Tabellenwerks unter einer Speichereinheit und einer Steuereinheit des Batterietestgeräts.

Erfindungsgemäß ist auch ein Batterietestsystem mit wenigstens einem Batterietestgerät im Sinne der Erfindung vorgesehen, welches vorzugsweise mittels eines Verfahrens im Sinne der Erfindung betrieben wird. Unter einem Batterietestsystem ist im Sinne der Erfindung insbesondere ein System zu verstehen, das die herkömmlichen Funktionalitäten eines Fahrzeugbatterietests, beispielsweise in einer Kfz-Werkstätte und/oder in einem Testlabor und/oder in einer KfZ-Fertigungslinie, aufweist.

Um die Qualität des Batterietyp-Tests weiter zu verbessern, ist das Batterietestgerät gemäß einer bevorzugten Weiterbildung so ausgebildet, dass während der Beaufschlagung mit dem Impuls zu einem dritten Zeitpunkt eine dritte Spannung der Batterie gemessen wird; in Abhängigkeit von einer zweiten Spannungsdifferenz zwischen der zweiten Spannung und der dritten Spannung eine Ausprägung eines zweiten Zuordnungsparameters ermittelt wird; und der getesteten Batterie in Abhängigkeit von der Ausprägung des zweiten Zuordnungsparameters ein bestimmter Batterietyp zugeordnet wird.

Gemäß einer bevorzugten Weiterbildung ist das Batterietestgerät so ausgebildet, dass in Abhängigkeit von der ersten Spannung eine Ausprägung eines dritten Zuordnungsparameters ermittelt wird; und der getesteten Batterie in Abhängigkeit von der Ausprägung des dritten Zuordnungsparameters ein bestimmter Batterietyp zugeordnet wird. Dadurch kann gegebenenfalls die Aussagegenauigkeit des Tests weiter verbessert werden.

Auch eine Strommessung kann gemäß einer bevorzugten Weiterbildung zu einer erhöhten Aussagegenauigkeit des Tests beitragen. Dazu ist das Batterietestgerät vorzugsweise mit einer Strommesseinheit ausgestattet und so ausgebildet, dass während der Beaufschlagung mit dem Impuls zu dem zweiten Zeitpunkt ein zweiter Strom der Batterie gemessen wird und zu einem dritten Zeitpunkt ein dritter Strom der Batterie gemessen wird; in Abhängigkeit von einer ersten Stromdifferenz zwischen dem zweiten Strom und dem dritten Strom eine Ausprägung eines vierten Zuordnungsparameters ermittelt wird; und der getesteten Batterie in Abhängigkeit von der Ausprägung des vierten Zuordnungsparameters ein bestimmter Batterietyp zugeordnet wird.

Um ein hinreichend verlässliches Testergebnis zu erhalten, kann es bei einer bevorzugten Weiterbildung sinnvoll sein, dass der Batterie nur dann ein Batterietyp zugewiesen wird, wenn wenigstens zwei, insbesondere drei oder vier der Zuordnungsparameter eine Ausprägung aufweisen, die demselben Batterietyp entspricht. Besonders bevorzugt wird dann nur ein Batterietyp zugewiesen, wenn der erste und der zweite Zuordnungsparameter eine Ausprägung aufweisen, die demselben Batterietyp entspricht. Vorzugsweise müssen dazu der erste, der zweite und der dritte Zuordnungsparameter das gleiche Ergebnis liefern.

Wenn mehrere Zuordnungsparameter in die letztendliche Zuordnung eines Batterietyps einbezogen werden, kann gemäß einer bevorzugten Weiterbildung vorgesehen sein, dass die verwendeten Zuordnungsparameter bei der Zuordnung eines Batterietyps gewichtet werden. Möglich ist dabei eine gleiche Gewichtung aller verwendeten Zuordnungsparameter, eine unterschiedliche Gewichtung aller verwendeten Zuordnungsparameter sowie eine gleiche Gewichtung einiger und eine unterschiedliche Gewichtung anderer Zuordnungsparameter.

Um eine gute Unterscheidung speziell zwischen Li-Ion-Batterien und Blei-Batterien zu gewährleisten, ist gemäß einer bevorzugten Weiterbildung vorgesehen, dass die Ausprägung des ersten Zuordnungsparameters und die Ausprägung des zweiten Zuordnungsparameters einer Batterie vom Typ Li-Ion zugeordnet wird, wenn sie kleiner ist als ein Spannungsdifferenz-Schwellenwert ist, und sonst einer Batterie vom Typ Blei zugeordnet wird. Für den ersten und den zweiten Zuordnungsparameter sind im Regelfall unterschiedliche Spannungsdifferenz-Schwellenwert vorgesehen.

Vorzugsweise wird die Ausprägung des dritten Zuordnungsparameters einer Batterie vom Typ Li-Ion zugeordnet, wenn sie größer als ein Spannungs-Schwellenwert ist, und sonst einer Batterie vom Typ Blei zugeordnet.

Weil die zu messenden Spannungswerte und/oder Spannungsdifferenz-Werte und/oder Stromwerte gegebenenfalls von verschiedenen Einflussfaktoren wie beispielsweise einer Temperatur, einer Alterung und/oder einem Ladezustand der Batterie sowie von anderen Störgrößen, insbesondere aus anderen Elektronikkomponenten des Fahrzeuges, abhängen kann, weist das Batterietestgerät in einer Ausführung eine Sensoranordnung auf, die wenigstens einen, vorzugsweise an sich bekannten, Sensor zur Erfassung eines Wertes einer Temperatur, eines Ladezustands und/oder eines Alterungszustands der Batterie aufweist und/oder eingerichtet ist, mit einem Batteriemanagementsystem einer zu messenden Batterie verbunden zu werden. Die Sensoranordnung kann auch wenigstens einen Sensor zur Erfassung von Werten einer Kapazität eines Fahrzeugbordnetzes aufweisen. Indem die genannten Parameter, welche beispielsweise die zu als Zuordnungsparameter zu messenden Spannungswerte und/oder Spannungsdifferenz-Werte und/oder Stromwerte ggfs. stark beeinflussen können, berücksichtigt werden können, kann die Zuordnung eines Batterietyps zu einer gemessenen Batterie entsprechend dieser Parameter angepasst werden. Die genannten Parameter können vorzugsweise im Sinne eines Zuordnungsparameters berücksichtigt werden und/oder, indem sie einen solchen Zuordnungsparameter beeinflussen.

Um Betriebszustände und/oder Umgebungsbedingungen der zu messenden Batterie berücksichtigen zu können, erfolgt die Zuordnung eines Batterietyps in Abhängigkeit von wenigstens einem gemessenen Wert einer Sensoranordnung des Batterietestgeräts und/oder eines Batteriemanagementsystems der zu messenden Batterie.

Gemäß einer bevorzugten Weiterbildung wird einem zu messenden Spannungswerte und/oder Spannungsdifferenz-Werte und/oder Stromwerte ein Batterietyp "Blei" zugeordnet, wenn die erste Spannungsdifferenz des ersten Zuordnungsparameters 0,6 V oder mehr beträgt und/oder wenn die zweite Spannungsdifferenz des zweiten Zuordnungsparameters mehr als 0,1 V beträgt und/oder wenn die erste Spannung des dritten Zuordnungsparameters weniger als 13 V beträgt.

In einer bevorzugten Weiterbildung wird einem zu messenden Spannungswerte und/oder Spannungsdifferenz-Werte und/oder Stromwerte ein Batterietyp "Li-Ion" zugeordnet, wenn die erste Spannungsdifferenz des ersten Zuordnungsparameters weniger als 0,6 V beträgt und/oder wenn die zweite Spannungsdifferenz des zweiten Zuordnungsparameters weniger als 0,1 V beträgt und/oder wenn die erste Spannung des dritten Zuordnungsparameters 13 V oder mehr beträgt.

Bezüglich des dritten Zuordnungsparameters können in bestimmten Anwendungsfällen auch Spannungsschwellenwerte 10 V oder 11 V infrage kommen.

Gemäß einer Ausführung weist das Batterietestgerät eine Schnittstelle zu Sensoren und/oder einem Batteriemanagementsystem der zu testenden Batterie auf, die eingerichtet ist, auf gemessene Werte einer Temperatur, eines Ladezustands und/oder eines Alterungszustands der Batterie zuzugreifen.

In einer bevorzugten Ausführung ist das Batterietestgerät eingerichtet, insbesondere mittels eines Batterietests im Sinne der Erfindung, verschiedene Batterietypen, vorzugsweise vom Typ "Li-Ion" und vom Typ "Blei" zu unterscheiden. Eine solche Unterscheidung erfolgt vorzugsweise anhand der Zuordnung zu einem dieser Batterietypen.

Vorteilhafte Ausbildungen der verschiedenen Aspekte der Erfindung sind Gegenstand der Unteransprüche. Weitere Merkmale, Vorteile und Anwendungsmöglichkeiten der Erfindung ergeben sich aus der nachfolgenden Beschreibung im Zusammenhang mit den Figuren. Es zeigen, teilweise schematisiert
- Fig. 1: in einer Schnittansicht ein Batterietestgerät nach einer Ausführung der Erfindung mit einer angeschlossenen, zu messenden Batterie;
- Fig. 2: ein U-t-Diagramm eines Testergebnisses für eine Li-Ion-Batterie bei Durchführung eines Verfahrens nach einer Ausführung der Erfindung;
- Fig. 3: ein U-t-Diagramm eines Testergebnisses für eine Blei-Batterie bei Durchführung eines Verfahrens nach einer Ausführung der Erfindung; und
- Fig. 4: ein Ablaufdiagramm eines Batterietests, der mit einem Batterietestgerät gemäß einer beispielhaften Ausführung der Erfindung nach einem Verfahren gemäß einer beispielhaften Ausführung der Erfindung durchgeführt wird.

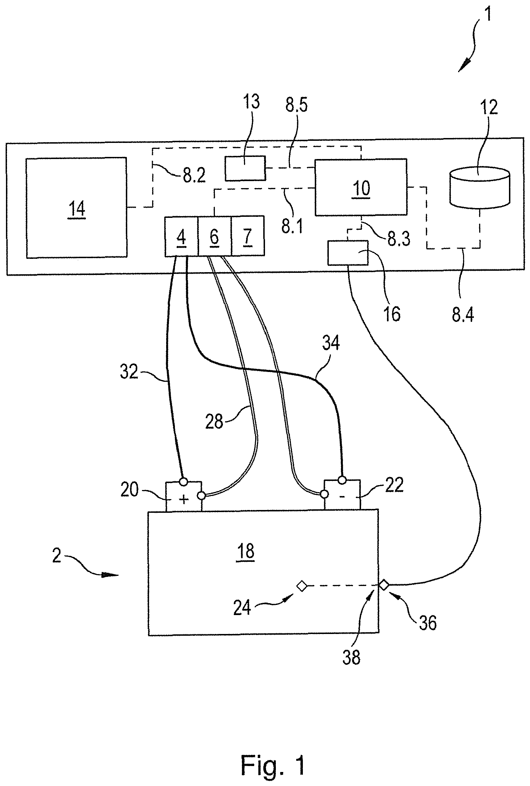

Die Figuren 1, 2 und 3 illustrieren ein Batterietestgerät nach einer Ausführung der Erfindung, welches mittels eines Verfahrens zur Erkennung eines Batterietyps nach einer Ausführung der Erfindung betrieben werden kann. Das beschriebene Batterietestgerät 1 ist insbesondere darauf ausgerichtet, in Kraftfahrzeugen verbaute Batterien 2 vom Batterietyp "Bleibatterie" und vom Batterietyp "Lithium-Ionen-Batterie" zu erkennen und voneinander zu unterscheiden. Selbstverständlich ist die Erfindung unabhängig davon auch auf beliebige andere Batterietypen anwendbar.

In Figur 1 ist ein Batterietestgerät 1 dargestellt, das zum Durchführen des Verfahrens zum Erkennen des Batterietyps an eine zu testende Batterie 2 angeschlossen ist.

Das Batterietestgerät 1 weist auf: eine Spannungsmesseinheit 4, einen Gleichstromgenerator 6 und optional eine Strommesseinheit 7. Mittels des Gleichstromgenerators 6 kann ein Gleichstromimpuls über eine Zeitdauer von einer oder einigen Sekunden oder länger erzeugt werden. Die Spannungsmesseinheit 4, ggf. die Strommesseinheit 7 und der Gleichstromstromgenerator 6 sind über die gestrichelt dargestellte Leitung 8.1 elektrisch und zur Signalübermittlung mit einer Steuereinheit 10 des Batterietestgeräts 1 verbunden. Die Steuereinheit 10 ist zusätzlich mittels weiterer Leitungen 8 mit einer Speichereinheit 12, einer Anzeigeeinheit 14 und einer Sensoranordnung 16 verbunden. Zudem ist die Steuereinheit 10 mittels einer weiteren Leitung 8.5 mit einem Zeitgeber 13 verbunden, der eine Beaufschlagung der zu testenden Batterie 2 mit dem Gleichstrompuls über eine vorbestimmte Zeitdauer, hier vorzugsweise fünf oder zehn Sekunden, ermöglicht. Der Zeitgeber ist vorzugsweise als herkömmlicher Bestandteil der Steuereinheit 10 ausgebildet.

Die zu testende Batterie 2 weist einen Energiespeicher 18 mit nicht dargestellten Sekundärzellen eines bestimmten Batterietyps sowie mit dem Energiespeicher 18 verbundene Pole 20 (positiv, durch das + dargestellt) und 22 (negativ, durch das - dargestellt) auf. Zusätzlich weist die Batterie 2 ein Batteriemanagementsystem 24 auf, welches nicht dargestellte Sensoren zur Erfassung einer Temperatur, eines Ladezustands und/oder eines Alterungszustands der Batterie aufweist.

Zum Durchführen des beispielhaften Verfahrens zur Erkennung des Batterietyps der zu testenden Batterie 2 ist jeder der Pole 20 und 22 mittels eines Anschlusses mit dem Batterietestgerät 1 verbunden. Der Anschluss weist für jeden Pol 20 und 22 einen Stromanschluss 28, 30 zur Beaufschlagung mit dem Gleichstrom und einen Messanschluss 32, 34 zur Spannungsmessung und damit zur Messung mehrerer Spannungswerte U zu verschiedenen Zeitpunkten t₁, t₂, t₃ und t₄ auf.

Zudem kann in diesem Ausführungsbeispiel optional an der Batterie 2 ein mit der Sensoranordnung 16 verbundener Temperatursensor 36 zur Messung der Oberflächen- und/oder Umgebungstemperatur der Batterie angeordnet sein. Dieser Sensor 36 ist dann im vorliegenden Ausführungsbeispiel nahe einer Schnittstelle 38 angeordnet, über die die Sensoranordnung 16 mit dem Batteriemanagementsystem 24 verbunden ist, könnte aber anwendungsspezifisch auch an einer anderen Stelle angeordnet sein.

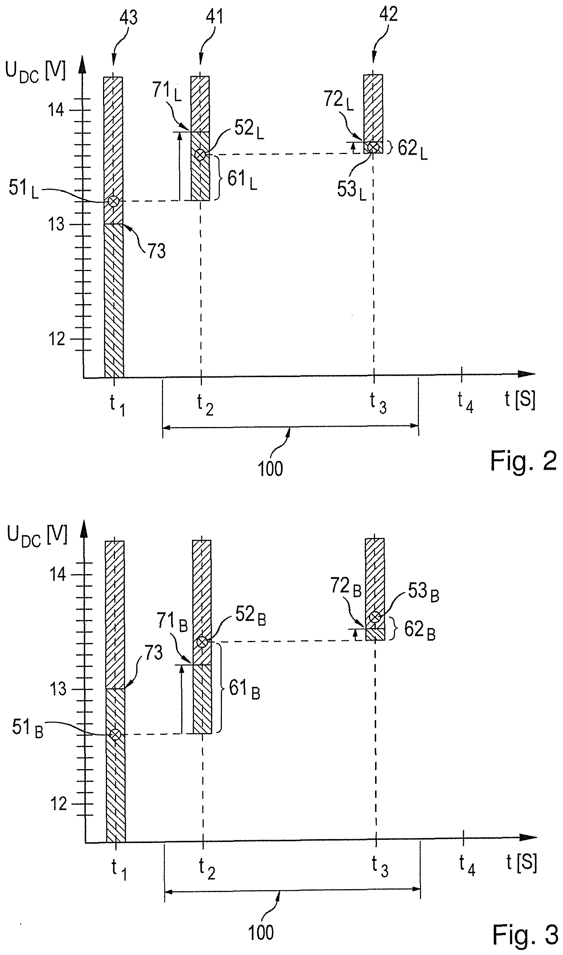

Nachfolgend wird anhand der Figuren 2 und 3 die Funktionsweise des Batterietestgeräts 1 gemäß der beschriebenen Ausführung eines Testverfahrens nach einer Ausführung der Erfindung dargestellt, bei der Lithiumionen-Batterien und Blei-Batterien unterschieden werden sollen.

In der gemäß Figuren 2 und 3 dargestellten Ausführung werden der erste Zuordnungsparameter 41, der zweite Zuordnungsparameter 42 und der dritte Zuordnungsparameter 43 berücksichtigt, um zu ermitteln, von welchem der beiden genannten Batterietypen die zu testende Batterie ist.

Der dritte Zuordnungsparameter 43 bezieht sich auf den Zeitpunkt T₁ vor Einsetzen des Gleichstromimpulses 100 und ist abhängig von der gemessenen ersten Spannung 51. Werte für die erste Spannung 51 von 13 V (dritter Schwellenwert 73) oder mehr werden Lithiumionen-Batterien zugeordnet, niedrigere Spannungen Blei-Batterien.

Der zweite Zuordnungsparameter 42 bezieht sich auf den Übergang von dem Zeitpunkt T₁ vor dem Einsetzen des Gleichstromimpulses 100 hin zum Zeitpunkt T₂ zu Beginn des Gleichstromimpulses 100 und ist abhängig von der ersten Spannungsdifferenz 61 zwischen der gemessenen ersten Spannung 51 und der gemessenen zweiten Spannung 52. Werte für die erste Spannungsdifferenz 61 von 0,6 V (erster Schwellenwert 71) oder mehr werden Blei-Batterien zugeordnet, niedrigere Spannungsdifferenzen Lithiumionen-Batterien.

Der erste Zuordnungsparameter 41 bezieht sich auf die Entwicklung der Spannung während des Gleichstromimpulses 100 und ist abhängig von der zweiten Spannungsdifferenz 62 zwischen der gemessenen zweiten Spannung 52 und der gemessenen dritten Spannung 53. Werte für die zweite Spannungsdifferenz 62 von 0,1 V (zweiter Schwellenwert 72) oder mehr werden Blei-Batterien zugeordnet, niedrigere Spannungsdifferenzen Lithiumionen-Batterien.

Ein Testergebnis (also die Aussage "Li-Ion-Batterie" oder die Aussage "Blei-Batterie") wird nur dann auf der Anzeige 14 ausgegeben, wenn die Ausprägung jedes der drei Zuordnungsparameter 41, 42 und 43 dem entsprechenden Batterietyp zugeordnet ist. Insofern sind die drei Zuordnungsparameter gleich gewichtet.

Der dritte Zuordnungsparameter ergibt sich aus der gemessenen ersten Spannung 51 und weist die Ausprägungen größer gleich 13 V und kleiner 13 V auf. Die Ausprägung größer gleich 13 V ist Batterien vom Typ "Li-Ion" zugeordnet, weil diese entsprechende Spannungen aufweisen. Die Ausprägung kleiner 13 V ist entsprechend Batterien vom Typ "Blei" zugeordnet.

In Fig. 2 ist der Fall dargestellt, dass aufgrund der Ausprägungen der drei Zuordnungsparameter 41, 42 und 43 der zu testenden Batterie der Batterietyp "Li-Ion" zugeordnet wird. Die erste Spannung 51_{L} zum Zeitpunkt T₁ beträgt 13,2 V und damit mehr als 13 V. Folglich wird diese Ausprägung des dritten Zuordnungsparameters 43 einer Lithiumionen-Batterie zugeordnet.

Die zweite Spannung 52_{L} zum Zeitpunkt T₂ beträgt 13,6 V. Die erste Spannungsdifferenz 61_{L} beträgt damit 0,4 V und folglich weniger als 0,6 V. Dementsprechend wird diese Ausprägung des ersten Zuordnungsparameters 41 einer Lithiumionen-Batterie zugeordnet.

Die dritte Spannung 53_{L} zum Zeitpunkt T₃ beträgt 13,65 V. Die zweite Spannungsdifferenz 62_{L} beträgt damit 0,05 V und folglich weniger als 0,1 V. Dementsprechend wird diese Ausprägung des zweiten Zuordnungsparameters 42 ebenso einer Lithiumionen-Batterie zugeordnet.

Da die Ausprägungen jedes der Zuordnungsparameter 41, 42 und 43 einer Lithiumionen-Batterie zugeordnet werden, wird als Testergebnis auf der Anzeige 14 "Li-Ion-Batterie" ausgegeben.

In Fig. 3 ist der Fall dargestellt, dass aufgrund der Ausprägungen der drei Zuordnungsparameter 41, 42 und 43 der zu testenden Batterie der Batterietyp "Blei" zugeordnet wird. Die erste Spannung 51_{B} zum Zeitpunkt t₁ beträgt 12,6 V und damit weniger als 13 V. Folglich wird diese Ausprägung des dritten Zuordnungsparameters 43 einer Blei-Batterie zugeordnet.

Die zweite Spannung 52_{B} zum Zeitpunkt t₂ beträgt 13,4 V. Die erste Spannungsdifferenz 61_{B} beträgt damit 0,8 V und folglich mehr als 0,6 V. Dementsprechend wird diese Ausprägung des ersten Zuordnungsparameters 41 einer Blei-Batterie zugeordnet.

Die dritte Spannung 53_{B} zum Zeitpunkt t₃ beträgt 13,6 V. Die zweite Spannungsdifferenz 62_{B} beträgt damit 0,2 V und folglich mehr als 0,1 V. Dementsprechend wird diese Ausprägung des zweiten Zuordnungsparameters 42 ebenso einer Blei-Batterie zugeordnet.

Da die Ausprägungen jedes der Zuordnungsparameter 41, 42 und 43 einer Blei-Batterie zugeordnet werden, wird als Testergebnis auf der Anzeige 14 "Blei-Batterie" ausgegeben.

Relevante Umgebungs- oder Betriebsbedingungen der zu testenden Batterie wie Temperatur, Ladezustand oder Alterungszustand können mittels der Sensoranordnung 16 und/oder einem Batteriemanagementsystem 24 der Batterie 2 aufgenommen werden und können ggf. in der dargestellten Ausführung in das Verlässlichkeitskriterium und/oder in die Beurteilung der Zuordnungsparameter und/oder als weitere Zuordnungsparameter einfließen.

Wenn in einer nicht dargestellten Ausführung diese Umgebungs- und/oder Betriebsbedingungen nicht mittels eines Batteriemanagementsystems der zu testenden Batterie ermittelt werden, können aktuelle Werte zur Temperatur der Batterie beispielsweise mittels eines anderen, nicht dargestellten Temperatursensors, insbesondere der Sensoranordnung 16, direkt an einem der beiden Batteriepole aufgenommen werden, an denen ohnehin die Anschlüsse 28, 30, 32 bzw. 34 anliegen. Einer dieser Anschlüsse kann eingerichtet sein, den Temperatursensor und seine Anbindung aufzunehmen, beispielsweise an einer Polklemme. Die Temperatur des metallischen Batteriepols kann für die Zwecke der Erfindung ausreichend repräsentativ für Temperaturen im Inneren der Batterie sein. Ein Ladezustand kann in einer solchen Ausführung in Abhängigkeit von einer an den Messanschlüssen 32, 34 anliegenden und gemessenen Spannung U ermittelt werden, ein Alterungszustand in Abhängigkeit von einem dann zu messenden Gleichstrom-Widerstand der Batterie.

Stromwerte, beispielsweise zu den Zeitpunkten t₂ und t₃ gemessen, werden im Ausführungsbeispiel der Fig. 2 und 3 nicht ermittelt und nicht zur Bestimmung des Batterietyps herangezogen. Jedoch wäre dies mit einem Batterietestgerät gemäß Fig. 1 im Umfang der Erfindung ohne weiteres möglich. Jedoch ist das Batterietestgerät gemäß Fig. 1 ausgebildet, solche Stromwerte zu messen und ermittelte Messwerte oder Messwertdifferenzen im Sinne der Erfindung zu verwenden.

Eine Messung von Strom- und/oder Spannungswerten zu einem Zeitpunkt t₄ nach dem Gleichstromimpuls wird im Ausführungsbeispiel der Fig. 2 und 3 nicht durchgeführt und nicht zur Bestimmung des Batterietyps herangezogen. Jedoch ist das Batterietestgerät gemäß Fig. 1 ausgebildet, solche Messungen durchzuführen und ermittelte Messwerte oder Messwertdifferenzen im Sinne der Erfindung zu verwenden.

In der vorgestellten Ausführung wird kein Batterietyp zugeordnet, wenn die Ergebnisse aus den Ausprägungen des ersten und zweiten Zuordnungsparameters, vorzugsweise auch des dritten Zuordnungsparameters, nicht zum selben Batterietyp führen. Ein nicht übereinstimmendes Ergebnis kann eine Wiederholung der Messung auslösen.

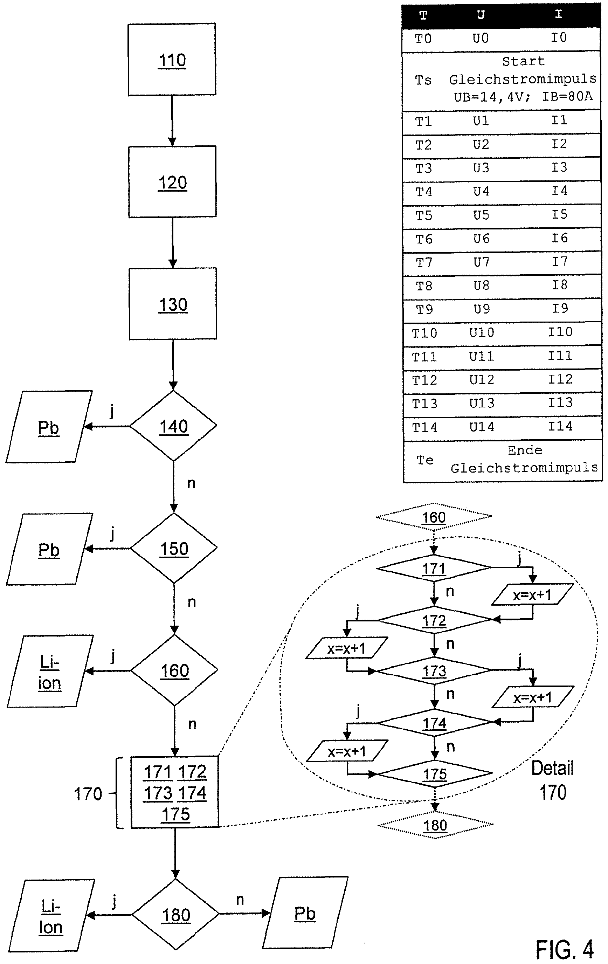

In Fig. 4 wird bezüglich des durchgeführten Verfahrens zur Erkennung eines Batterietyps ein Ausführungsbeispiel beschrieben, das von dem der Figuren 1 bis 3 unabhängig ist; das dazu verwendete Batterietestgerät kann dem aus Fig. 1 entsprechen, kann aber auch gemäß einer anderen beispielhaften Ausführung der Erfindung ausgebildet sein. Gezeigt ist in Fig. 4 ein Ablaufdiagramm eines Batterietests, der mit einem Batterietestgerät 1 gemäß einer beispielhaften Ausführung der Erfindung nach einem Verfahren gemäß einer beispielhaften Ausführung der Erfindung durchgeführt wird.

Der Batterietest nach diesem Ausführungsbeispiel dient einer Unterscheidung von in einem Kraftfahrzeug angeschlossenen Batterien. Bei vielen gegenwärtigen Fahrzeugmodellen ist abhängig von der vorgesehenen Serien- bzw. Sonderausstattung entweder eine Batterie vom Typ Lithiumionen (Li-Ion) oder eine Batterie vom Typ Blei (Pb) vorgesehen. Mit der in Fertigungslinien für Kraftfahrzeuge vorgesehenen Just-in-Time- oder Just-in-Sequence-Fertigung kommt es regelmäßig vor, dass in einer Fertigungslinie nacheinander in unregelmäßiger Anordnung Fahrzeuge mit eingebauter Bleibatterie und mit eingebauter Lithiumionen-Batterie weitermontiert werden.

Für verschiedene Funktionen - wie beispielsweise das Aufladen der Fahrzeugbatterie gemäß Vorgaben des Fahrzeugkunden oder des Fahrzeugherstellers - muss ein an der Fertigungslinie vorgesehenes Aufladegerät unter anderem ein Batterietestgerät 1 zur Erkennung des Batterietyps der verbauten Batterie 18 aufweisen. Ein solches Batterietestgerät 1 und die Durchführung eines Batterietests zum Erkennen des Batterietyps wird in diesem Ausführungsbeispiel beschrieben. Nachfolgend sind die einzelnen Schritte des Verfahrens mit den funktionalen Zusammenhängen detailliert beschrieben und erläutert:
In Schritt 110 wird die Fahrzeugbatterie 18 im angeschlossenen Zustand an das Bordnetz des Fahrzeuges an das Batterietestgerät 1 angeschlossen, in dem die Anschlüsse 28, 30, 32 und 34 an die Pole 20 und 22 angeklemmt werden.

In Schritt 120 - also vor der Beaufschlagung der Batterie mit dem Gleichstromimpuls - wird zu einem Zeitpunkt T0 die Vorimpulsspannung U0 und der Vorimpulsstrom 10 der Batterie gemessen.

In Schritt 130 wird die Batterie während einer Zeitdauer ΔT von zehn Sekunden mit einem Gleichstromimpuls einer Spannung von 14,4 V und einer Stromstärke von 80 A beaufschlagt. Der Gleichstromimpuls liegt dabei an der Batterie vom Startzeitpunkt Ts bis zum Endzeitpunkt Te an. Der Messzeitpunkt T0 liegt vor dem Startzeitpunkt Ts; die Messpunkte T1 bis T14 liegen zwischen dem Startzeitpunkt Ts und der Endzeitpunkt Te (vergleiche Tabelle in Fig. 4). In anderen Ausführungsbeispielen kann eine Beaufschlagung mit einer anderen Spannung und/oder einer anderen Stromstärke vorgesehen sein.

Während der Beaufschlagung mit dem Gleichstromimpuls werden in, vorzugsweise gleich verteilten, Zeitabständen zu verschiedenen Zeitpunkten T1 bis T14 jeweils eine Impulsspannung U1 bis U14 und ein Impulsantwortstrom I1 bis I14 gemessen.

Auf Basis der gemessenen Spannungen U0 bis U14 und Antwortströme I0 bis I14 werden in den Verfahrensschritten 140 bis 180 die jeweiligen Ausprägungen verschiedener Zuordnungsparameter ermittelt.

Aus der jeweils ermittelten Ausprägung wird vorzugsweise für jeden verwendeten Zuordnungsparameter in einen Vergleich mit einem hinterlegten Tabellenwerk für diesen Zuordnungsparameter ermittelt, ob und wenn ja welchen Batterietyp die getestete Batterie bezüglich dieses Zuordnungsparameters zuzuordnen ist. Das entsprechende Tabellenwerk enthält vorzugsweise eine Mehrzahl zu erwartender Ausprägungen bezüglich des Zuordnungsparameters zu jeder dieser Ausprägungen die Zuordnung zu einem Batterietyp.

Die im beschriebenen Ausführungsbeispiel zur Unterscheidung von Bleibatterien und Lithiumionen-Batterien verwendeten Zuordnungsparameter sind nachfolgend im Zusammenhang mit demjenigen Verfahrensschritt beschrieben, in welchem sie angewendet werden:
Die Schritte 140 bis 160 dienen insbesondere, aber nicht ausschließlich, einer möglichst einfachen Unterscheidung vollständig aufgeladener Batterien unterschiedlicher Batterietypen.

In Schritt 140 wird eine Ausprägung eines Beaufschlagungs-Stromdifferenz-Parameters aus der Beaufschlagungs-Stromdifferenz zwischen dem Beaufschlagungsstrom IB und dem letzten gemessenen Impulsantwortstrom I14 ermittelt. Wenn diese Stromdifferenz größer als ein Schwellenwert ist (insbesondere größer als fünf bis 20 Ampere, beispielsweise größer als 10 Ampere), wird bezüglich dieses Zuordnungsparameters der zu testenden Batterie der Batterietyp Pb zugeordnet.

Zudem wird im Schritt 140 eine Ausprägung eines Impulsstromdifferenzparameters aus einer Stromdifferenz zwischen dem ersten Impulsantwortstrom I1 und einem späteren Impulsantwortstrom (beispielsweise 14 oder 19) ermittelt. Wenn diese Stromdifferenz ergibt, dass der später gemessene Impulsantwortstrom größer, insbesondere deutlich größer, ist als der früher gemessene, wird bezüglich dieses Zuordnungsparameters der zu testenden Batterie der Batterietyp Pb zugeordnet.

Wenn die beiden in Schritt 140 ermittelten Zuordnungen auf eine Bleibatterie verweisen, wird der zu testenden Batterie der Batterietyp Pb zugewiesen (Vergleiche "j" an dem Pfeil von dem Verfahrensschritt 140 in Fig. 4 zu der Zuweisung "Pb").

Wenn in Schritt 140 keine eindeutige Zuordnung zu einer Bleibatterie möglich ist (vergleiche "n"), wird in Schritt 150 zusätzlich ein Vorimpulsspannungs-Parameter herangezogen. Ist die Vorimpulsspannung U0 kleiner als ein Schwellenwert (insbesondere kleiner als 12,5 bis 12,9 Volt, beispielsweise kleiner als 12,8 Volt), wird bezüglich dieses Zuordnungsparameters der zu testenden Batterie der Batterietyp Pb zugeordnet. Dieses Kriterium erfüllen fast alle Bleibatterien, gegebenenfalls mit Ausnahme von solchen die unmittelbar zuvor geladen wurden.

Wenn zusätzlich zu der in Schritt 150 ermittelten Zuordnung auch die in Schritt 140 ermittelte Zuordnung bezüglich des Beaufschlagungs-Stromdifferenz-Parameters auf eine Bleibatterie verweist, wird der zu testende Batterie der Batterietyp Pb zugewiesen (Vergleiche "j" an dem Pfeil von dem Verfahrensschritt 150 in Fig. 4 zu der Zuweisung "Pb").

Wenn auch in Schritt 150 keine eindeutige Zuordnung zu einer Bleibatterie möglich ist (vergleiche "n"), wird in Schritt 160 zusätzlich ein weiterer Vorimpulsspannungs-Parameter herangezogen. Ist die Vorimpulsspannung U0 größer als ein Schwellenwert (hier insbesondere größer als 12,9 bis 13,6 Volt, beispielsweise größer als 13,2 Volt), wird bezüglich dieses Zuordnungsparameters der zu testenden Batterie der Batterietyp Li-Ion zugeordnet.

Zudem wird im Schritt 160 eine Ausprägung eines weiteren Impulsstromdifferenzparameters aus einer Stromdifferenz zwischen dem ersten Impulsantwortstrom I1 und dem letzten Impulsantwortstrom I14 ermittelt. Wenn diese Stromdifferenz ergibt, dass während des fortschreitenden Impulses die Stromstärke um mehr als einen Schwellenwert (insbesondere größer als fünf bis 20 Ampere, beispielsweise größer als 10 Ampere) sinkt, wird bezüglich dieses Zuordnungsparameters der zu testenden Batterie der Batterietyp Li-Ion zugeordnet.

Wenn die beiden in Schritt 160 ermittelten Zuordnungen auf eine Lithiumionen-Batterie verweisen, wird der zu testenden Batterie der Batterietyp Li-Ion zugewiesen (Vergleiche "j" an dem Pfeil von dem Verfahrensschritt 160 in Fig. 4 zu der Zuweisung "Li-Ion").

Je nach Anwendungsfall und benötigter Aussagegenauigkeit kann insbesondere zur Unterscheidung vollgeladener Batterien auch im hier beschriebenen Ausführungsbeispiel ausreichend sein, nur einen oder zwei der Schritte 140, 150 und 160 durchzuführen, um der zu testenden Batterie einen Batterietyp zuzuweisen.

Die Schritte 170 bis 180 dienen insbesondere, aber nicht ausschließlich, einer möglichst einfachen Unterscheidung von nicht vollgeladenen Batterien unterschiedlicher Batterietypen. Mittels dieser Schritte wird also auch eine Erkennung des Batterietyps für Batterien in einem beliebigen Ladezustand ermöglicht.

In Schritt 170 erfolgt eine gemeinsame Betrachtung mehrerer unterschiedlicher Zuordnungsparameter, zu denen in den Teilschritten 171 bis 175 die jeweilige Ausprägung der zu testenden Batterie ermittelt wird.

Zu jedem der Teilschritte 171 bis 175 - also dem jeweilig zugehörigen Zuordnungsparameter - wird ermittelt, ob dessen Ausprägung im Vergleich mit dem jeweiligen Tabellenwerk einer Lithiumionen-Batterie zuzuordnen ist. Ist dies der Fall (vergleiche "j" in der Detailansicht zu Schritt 170), wird ein Zähler x um eine Stufe erhöht (x = x + 1).

In Schritt 180 wird der zu testenden Batterie der Batterietyp Li-Ion zugeordnet, wenn der Zähler x einen gewissen Schwellenwert erreicht (vergleiche Zuweisung "j" bei Schritt 180), vorliegend beispielsweise Schwellenwert von drei. Im Ausführungsbeispiel heißt das, dass der Batterietyp Li-Ion zugewiesen wird, wenn wenigstens drei der Zuordnungsparameter 171 bis 175 eine Zuordnung zum Batterietyp Li-Ion ergeben. Ist dies nicht der Fall, wird der Batterietyp Pb zugewiesen (vergleiche Zuweisung "n").

Die Zuordnungsparameter der Teilschritte 171 bis 175 sind nachfolgend näher beschrieben:
In Teilschritt 171 wird ein weiterer Vorimpulsspannungs-Parameter herangezogen. Erreicht die Vorimpulsspannung U0 einen Schwellenwert oder ist größer als dieser (hier insbesondere größer gleich 12,5 bis 13,2 Volt, beispielsweise größer gleich 12,8 Volt), wird bezüglich dieses Zuordnungsparameters der zu testenden Batterie der Batterietyp Li-Ion zugeordnet.

In Teilschritt 172 wird ein Übergangs-Spannungsdifferenz-Parameter herangezogen, dessen Ausprägung aus einer Spannungsdifferenz zwischen der Vorimpulsspannung U0 und der ersten Impulsspannung U1 ermittelt wird. Ergibt diese Spannungsdifferenz, dass nach dem Beaufschlagen der Batterie mit dem Gleichstromimpuls die Spannung um weniger als einen Schwellenwert (hier insbesondere 1,5 bis 2,2 Volt, beispielsweise 1,8 Volt) steigt, wird bezüglich dieses Zuordnungsparameters der zu testenden Batterie der Batterietyp Li-Ion zugeordnet.

In Teilschritt 173 wird eine Ausprägung eines Impuls-Spannungsdifferenz-Parameters aus einer Spannungsdifferenz zwischen der ersten Impulsspannung U1 und der letzten Impulsspannung U14 ermittelt. Wenn diese Spannungsdifferenz ergibt, dass während des fortschreitenden Impulses die Spannung um weniger als einen Schwellenwert (insbesondere weniger als 0,20 bis 0,40 Volt, beispielsweise weniger als 0,30 Volt) steigt, wird bezüglich dieses Zuordnungsparameters der zu testenden Batterie der Batterietyp Li-Ion zugeordnet.

In Teilschritt 174 wird eine Ausprägung eines Spannungsdifferenz-Mittelwert-Parameters ermittelt, indem ein Mittelwert auftretender Spannungsdifferenzen zwischen zeitlich allen Paaren zeitlich benachbart gemessenen Spannungen ermittelt wird (Mittelwert von [U1-U0, U2-U1, ..., U14-U13]).

Ist dieser Mittelwert kleiner als ein Schwellenwert (insbesondere kleiner als 0,1 bis 0,2 Volt, beispielsweise kleiner als 0,16 Volt), wird bezüglich dieses Zuordnungsparameters der zu testenden Batterie der Batterietyp Li-Ion zugeordnet. Als weitere, hier nicht betrachtet Zuordnungsparameter kann auch eine mittlere absolute Abweichung der Spannungsdifferenz von dem in Teilschritten 174 berechneten Mittelwert in Betracht gezogen werden.

In Teilschritt 175 wird eine Ausprägung eines Spannungsdifferenz-Ableitung-Parameters ermittelt, indem eine zeitliche Entwicklung der Spannungsänderungen zwischen zeitlich benachbart gemessenen Spannungen ermittelt wird. Dazu kann beispielsweise ein Verfahren der numerischen Integration mit zunehmenden Differenzenquotienten angewendet werden. Wenn der derart ermittelte Wert für die Ableitung unter einem bestimmten Schwellenwert bleibt (insbesondere kleiner als 0,05 bis 0,1 , beispielsweise kleiner als 0,075), wird bezüglich dieses Zuordnungsparameters der zu testenden Batterie der Batterietyp Li-Ion zugeordnet.

Je nach Anwendungsfall und benötigter Aussagegenauigkeit kann insbesondere zur Unterscheidung beliebig teilgeladener Batterien auch im hier beschriebenen Ausführungsbeispiel ausreichend sein, nur einen oder zwei oder drei oder vier der Teilschritte 171, 172, 173, 174 und 175 durchzuführen, um der zu testenden Batterie einen Batterietyp zuzuweisen.

Wenn in diesem Sinne eine andere Anzahl an Zuordnungsparameter im Rahmen des Schrittes 170 herangezogen wird als in Fig. 4 dargestellt, kann entsprechend auch der Schwellenwert bezüglich des Zählers x zur Zuweisung eines bestimmten Batterietyps angepasst werden. Unabhängig von der Anzahl der betrachteten Zuordnungsparameter in Schritt 170 kann über eine spezifisch auf einen bestimmten Zuordnungsparameter angepasste Zählererhöhung y (x = x + y) eine Gewichtung der einzelnen Zuordnungsparameter erfolgen, wenn die Ausprägung eines oder mehrerer bestimmter Zuordnungsparameter für die Zuweisung des Batterietyps als relevanter ist als die Ausprägung eines oder mehrerer anderer Zuordnungsparameter.

Beispielsweise wenn sichergestellt ist, dass die zu testende Batterie zwar an das Fahrzeug angeschlossen ist, aber keine großen Verbraucher wie beispielsweise eine Klimaanlage oder eine Sitzheizung so gestaltet sind, eine zuverlässige Erkennung des Batterietyps vorzugsweise auch nur auf Basis der Schritte 110, 120, 130, 150, 172, 173 und 174 durchgeführt werden.

## Patentansprüche

1. Verfahren zur Erkennung des Batterietyps (Pb, Li-Ion) einer über das Bordnetz an die Verbraucher eines Fahrzeuges angeschlossenen Batterie mittels eines Batterietestgeräts (1), **gekennzeichnet durch** die Schritte:
- Beaufschlagen einer zu testenden Batterie (18) mit einem Gleichstromimpuls mit einer Stromstärke (IB) von wenigstens 30 Ampere während wenigstens fünf Sekunden,
- vor dem Beaufschlagen Messen einer Vorimpulsspannung (U0) der Batterie,
- während dem Beaufschlagen Messen einer Impulsspannung (U1) der Batterie,
- Ermitteln einer Übergangs-Spannungsdifferenz zwischen der Vorimpulsspannung und der Impulsspannung,
- Ermitteln einer Ausprägung eines Übergangs-Spannungsdifferenz-Parameters in Abhängigkeit von der Übergangs-Spannungsdifferenz,
- in Abhängigkeit von der Ausprägung Zuordnen eines bestimmten Batterietyps (Pb, Li-Ion) zu der getesteten Batterie.

2. Verfahren gemäß Anspruch 1, wobei der Gleichstromimpuls eine wenigstens im Wesentlichen konstante Stromstärke (IB) im Bereich von zwischen 60 und 120 Ampere aufweist.

3. Verfahren gemäß Anspruch 1 oder 2, wobei die Batterie mit dem Gleichstromimpuls während einer Zeitdauer im Bereich von zwischen acht und 15 Sekunden beaufschlagt wird.

4. Verfahren gemäß einem der vorherigen Ansprüche, aufweisend:
- Messen wenigstens einer weiteren Impulsspannung (U2-U14) der Batterie zu wenigstens einem weiteren Zeitpunkt (T2-T14) während der Beaufschlagung,
- Ermitteln einer Ausprägung wenigstens eines Impuls-Spannungsdifferenz-Parameters in Abhängigkeit von einer Impuls-Spannungsdifferenz zwischen zwei gemessenen Impulsspannungen,
- in Abhängigkeit von der Ausprägung Zuordnen eines bestimmten Batterietyps zu der getesteten Batterie.

5. Verfahren gemäß Anspruch 4, wobei zu mehreren, insbesondere insgesamt zehn oder fünfzehn, Zeitpunkten (T1-T14) während der Beaufschlagung eine Impulsspannung (U1-U14) der Batterie gemessen wird, und wobei eine Ausprägung wenigstens eines weiteren Impuls-Spannungsdifferenz-Parameters in Abhängigkeit von wenigstens einer Impuls-Spannungsdifferenz zwischen zwei der gemessenen Impulsspannungen ermittelt wird, und wobei in Abhängigkeit von der Ausprägung ein bestimmter Batterietyp zu der getesteten Batterie zugeordnet wird.

6. Verfahren gemäß Anspruch 4 oder 5, wobei in Abhängigkeit von einem Mittelwert auftretender Spannungsdifferenzen zwischen zeitlich benachbart vor und während der Beaufschlagung gemessenen Spannungen eine Ausprägung eines Spannungsdifferenz-Mittelwert-Parameters ermittelt wird, und wobei in Abhängigkeit von der Ausprägung ein bestimmter Batterietyp zu der getesteten Batterie zugeordnet wird.

7. Verfahren gemäß Anspruch 4 oder 5, wobei in Abhängigkeit von einer zeitlichen Entwicklung der Spannungsänderungen zwischen zeitlich benachbart vor und während der Beaufschlagung gemessenen Spannungen eine Ausprägung eines Spannungsdifferenz-Ableitungs-Parameters ermittelt wird, und wobei in Abhängigkeit von der Ausprägung ein bestimmter Batterietyp zu der getesteten Batterie zugeordnet wird.

8. Verfahren gemäß Anspruch 4 oder 5, wobei in Abhängigkeit von der Zuordnung der getesteten Batterie zu einem bestimmten Batterietyp bezüglich des Übergangs-Spannungsdifferenz-Parameters und der Impuls-Spannungsdifferenz-Parameter eine Zuweisung eines bestimmten Batterietyps als Testergebnis erfolgt, wenn bezüglich aller oder eines vorbestimmten Anteils der betrachteten Spannungsdifferenz-Parameter eine Ausprägung vorliegt, die demselben Batterietyp (Pb, Li-Ion) zugeordnet ist.

9. Batterietestgerät (1) für eine über das Bordnetz an die Verbraucher eines Fahrzeuges angeschlossene Fahrzeugbatterie, aufweisend eine Spannungsmesseinheit (4), **gekennzeichnet dadurch, dass** das Batterietestgerät einen Stromimpulsgenerator (6) zur Erzeugung eines Gleichstromimpulses (100) aufweist, wobei die Spannungsmesseinheit und der Stromimpulsgenerator jeweils mit den Polen (20, 22) der zu testenden Fahrzeugbatterie (2) verbunden werden können, und dadurch, dass das Batterietestgerät eingerichtet ist,
- zu mehreren Zeitpunkten (T0-T14) vor und während einer Beaufschlagung der Fahrzeugbatterie mit einem Gleichstromimpuls mit einer Stromstärke (IB) von wenigstens 30 Ampere während wenigstens fünf Sekunden jeweils eine Spannung (U0-U14) der Batterie zu messen,
- aus wenigstens einem, insbesondere mehreren, Paaren von gemessenen Spannungen jeweils eine Spannungsdifferenz zu ermitteln,
- in Abhängigkeit von der/n ermittelten Spannungsdifferenz(en) jeweils eine Ausprägung eines Spannungsdifferenz-Parameters zu ermitteln,
- bezüglich jedes Spannungsdifferenz-Parameters der getesteten Fahrzeugbatterie in Abhängigkeit von der jeweiligen Ausprägung einen bestimmten Batterietyp (Pb, Li-Ion) zuzuordnen.

10. Batterietestgerät gemäß Anspruch 9, welches mittels eines Verfahrens gemäß einem der Ansprüche 1 bis 8 betrieben wird.

## Claims

1. Method for identifying the battery type (Pb, Li-Ion) of a battery connected to the consumer loads of a vehicle via the vehicle electrical system by means of a battery testing device (1), having the steps:
- application of a DC pulse having a current strength (IB) of at least 30 Ampere to a battery (18) to be tested for at least five seconds,
- before the application measurement of a pre-pulse voltage (U0) of the battery,
- during the application measurement of a pulse voltage (U1) of the battery,
- determining a transition voltage difference between the pre-pulse voltage and the pulse voltage,
- determining a characteristic of a transition voltage difference parameter as a function of the transition voltage difference,
- assigning a specific battery type (Pb, Li-ion) to the tested battery as a function of the characteristic.

2. Method according to claim 1, wherein the DC pulse has an at least substantially constant current strength (IB) in the range from 60 to 120 Ampere.

3. Method according to claim 1 or 2, wherein the DC pulse is applied to the battery for a period of time in the range from eight to 15 seconds.

4. Method according to one of the preceding claims, comprising:
- measuring at least one further pulse voltage (U2-U14) of the battery at at least one further time (T2-T14) during the application,
- determining a characteristic of at least one pulse voltage difference parameter as a function of a pulse voltage difference between two measured pulse voltages,
- assigning a specific battery type to the tested battery as a function of the characteristic.

5. Method according to claim 4, wherein a pulse voltage (U1-U14) of the battery is measured at a plurality of, in particular a total of ten or fifteen, times (T1-T14) during the application, and wherein a characteristic of at least one further pulse voltage difference parameter is determined as a function of at least one pulse voltage difference between two of the measured pulse voltages, and wherein a specific battery type is assigned to the tested battery as a function of the characteristic.

6. Method according to claim 4 or 5, wherein a characteristic of a voltage difference mean value parameter is determined as a function of an average value of voltage differences occurring between voltages measured temporally adjacent before and during the application, and wherein a specific battery type is assigned to the tested battery as a function of the characteristic.

7. Method according to claim 4 or 5, wherein a characteristic of a voltage difference derivative parameter is determined as a function of a temporal development of the voltage changes between voltages measured temporally adjacent before and during the application, and wherein a specific battery type is assigned to the tested battery as a function of the characteristic.

8. Method according to claim 4 or 5, wherein, as a function of the assignment of the tested battery to a specific battery type with respect to the transition voltage difference parameter and the pulse voltage difference parameter, a specific battery type is assigned as a test result, if with respect to all or a predetermined portion of the voltage difference parameters under consideration, a characteristic is present which is assigned to the same battery type (Pb, Li-ion).

9. Battery testing device (1) for a vehicle battery connected to the consumer loads of a vehicle via the vehicle electrical system, comprising a voltage measuring unit (4), **characterized in that** the battery testing device comprises a current pulse generator (6) for generating a DC pulse (100), the voltage measuring unit and the current pulse generator each being connectable to the terminals (20, 22) of the vehicle battery (2) to be tested, and **in that** the battery testing device is configured to,
- measuring a voltage (U0-U14) of the battery at several times (T0-T14) before and during application of a DC pulse with a current strength (IB) of at least 30 Ampere to the vehicle battery for at least five seconds in each case,
- determining a voltage difference from at least one, in particular several, pairs of measured voltages,
- determining a respective characteristic of a voltage difference parameter as a function of the voltage difference(s) determined,
- assigning a specific battery type (Pb, Li-ion) to the tested vehicle battery with regard to each voltage difference parameter as a function of the respective characteristic.

10. Battery testing device according to claim 9, which is operated by means of a method according to one of claims 1 to 8.

## Revendications

1. Procédé d'identification du type de batterie (Pb, Li-Ion) d'une batterie connectée aux charges de consommation d'un véhicule via le système électrique du véhicule au moyen d'un dispositif de test de batterie (1), comprenant les étapes suivantes:
- application d'une impulsion CC ayant une intensité de courant (IB) d'au moins 30 ampères à une batterie (18) à tester pendant au moins cinq secondes,
- avant l'application, mesure d'une tension de préimpulsion (U0) de la batterie,
- pendant l'application mesure d'une tension d'impulsion (U1) de la batterie,
- déterminer une différence de tension de transition entre la tension de préimpulsion et la tension d'impulsion,
- déterminer une caractéristique d'un paramètre de différence de tension de transition en fonction de la différence de tension de transition,
- attribuer un type de batterie spécifique (Pb, Li-ion) à la batterie testée en fonction de la caractéristique.

2. Procédé selon la revendication 1, dans laquelle l'impulsion CC a une intensité de courant (IB) au moins sensiblement constante dans la plage de 60 à 120 ampères.

3. Procédé selon la revendication 1 ou 2, dans laquelle l'impulsion CC est appliquée à la batterie pendant une durée comprise entre 8 et 15 secondes.

4. Procédé selon l'une des revendications précédentes, comprenant :
- mesurer au moins une autre tension d'impulsion (U2-U14) de la batterie à au moins un autre moment (T2-T14) pendant l'application,
- déterminer une caractéristique d'au moins un paramètre de différence de tension d'impulsion en fonction d'une différence de tension d'impulsion entre deux tensions d'impulsion mesurées,
- attribuer un type de batterie spécifique à la batterie testée en fonction de la caractéristique.

5. Procédé selon la revendication 4, dans laquelle une tension d'impulsion (U1-U14) de la batterie est mesurée à plusieurs reprises, en particulier dix ou quinze fois au total (T1-T14) pendant l'application, et dans laquelle une caractéristique d'au moins un autre paramètre de différence de tension d'impulsion est déterminée en fonction d'au moins une différence de tension d'impulsion entre deux des tensions d'impulsion mesurées, et dans laquelle un type de batterie spécifique est attribué à la batterie testée en fonction de la caractéristique.

6. Procédé selon la revendication 4 ou 5, dans laquelle une caractéristique d'un paramètre de valeur moyenne de différence de tension est déterminée en fonction d'une valeur moyenne de différences de tension survenant entre des tensions mesurées temporellement adjacentes avant et pendant l'application, et dans laquelle un type de batterie spécifique est attribué à la batterie testée en fonction de la caractéristique.

7. Procédé selon la revendication 4 ou 5, dans laquelle une caractéristique d'un paramètre dérivé de différence de tension est déterminée en fonction d'une évolution temporelle des variations de tension entre des tensions mesurées de manière temporellement adjacente avant et pendant l'application, et dans laquelle un type de batterie spécifique est attribué à la batterie testée en fonction de la caractéristique.

8. Procédé selon la revendication 4 ou 5, dans laquelle, en fonction de l'affectation de la batterie testée à un type de batterie spécifique par rapport au paramètre de différence de tension de transition et au paramètre de différence de tension d'impulsion, un type de batterie spécifique est affecté en tant que résultat de test, si par rapport à la totalité ou à une partie prédéterminée des paramètres de différence de tension considérés, une caractéristique est présente qui est affectée au même type de batterie (Pb, Li-ion).

9. Testeur de batterie (1) pour une batterie de véhicule connectée aux charges de consommation d'un véhicule via le système électrique du véhicule, comprenant une unité de mesure de la tension (4), **caractérisé en ce que** le dispositif de test de batterie comprend un générateur d'impulsions de courant (6) pour générer une impulsion CC (100), l'unité de mesure de la tension et le générateur d'impulsions de courant pouvant chacun être connectés aux bornes (20, 22) de la batterie de véhicule (2) à tester, et **en ce que** le dispositif de test de batterie est configuré pour,
- mesurer une tension (U0-U14) de la batterie à plusieurs moments (T0-T14) avant et pendant l'application d'une impulsion de courant continu d'une intensité de courant (IB) d'au moins 30 ampères à la batterie du véhicule pendant au moins cinq secondes dans chaque cas,
- déterminer une différence de tension à partir d'au moins une, en particulier plusieurs, paires de tensions mesurées,
- déterminer une caractéristique respective d'un paramètre de différence de tension en fonction de la (des) différence(s) de tension déterminée(s),
- attribuer un type de batterie spécifique (Pb, Li-ion) à la batterie du véhicule testée en ce qui concerne chaque paramètre de différence de tension en fonction de la caractéristique respective.

10. Testeur de batterie selon la revendication 9 fonctionnant au moyen d'une méthode selon l'une des revendications 1 à 8.
